(19) **Europäisches Patentamt / European Patent Office / Office européen des brevets**

(11) **EP 4 764 703 A1**

(12) # DEMANDE DE BREVET EUROPEEN

(43) Date de publication:
24.06.2026 Bulletin 2026/26

(21) Numéro de dépôt: 25223754.0

(22) Date de dépôt: 16.12.2025

(51) Classification Internationale des Brevets (IPC):
$G03F\ 7/00^{(2006.01)}$     $G03F\ 7/095^{(2006.01)}$
$G03F\ 7/20^{(2006.01)}$     $G02B\ 3/00^{(2006.01)}$

(52) Classification Coopérative des Brevets (CPC):
G03F 7/70416; G02B 3/0031; G03F 7/0005;
G03F 7/0035; G03F 7/095; G03F 7/203;
G03F 7/70466

(84) Etats contractants désignés:
AL AT BE BG CH CY CZ DE DK EE ES FI FR GB GR HR HU IE IS IT LI LT LU LV MC ME MK MT NL NO PL PT RO RS SE SI SK SM TR
Etats d'extension désignés:
BA
Etats de validation désignés:
GE KH LA MA MD TN

(30) Priorité: 17.12.2024 FR 2414379

(71) Demandeur: **Commissariat à l'Energie Atomique et aux Energies Alternatives**
**75015 Paris (FR)**

(72) Inventeurs:
• PALANCHOKE, Ujwol
38054 Grenoble Cedex 09 (FR)
• TOMASO, Florian
38054 Grenoble Cedex 09 (FR)

(74) Mandataire: **Hautier IP**
**20, rue de la Liberté**
**06000 Nice (FR)**

(54) ## PROCÉDÉ DE PHOTOLITHOGRAPHIE À ÉCHELLE DE GRIS À PRÉCISION AMÉLIORÉE

(57) L'invention concerne un procédé de lithographie en échelle de gris comprenant une fourniture d'un substrat (10) recouvert d'une première couche de résine photosensible (20), une exposition de cette couche à un premier rayonnement d'insolation (R1) au travers d'un premier masque (100), et un développement. Le premier masque est configuré pour former dans la résine un ensemble de premières structures (25) présentant chacune une hauteur comprise dans une première gamme de hauteurs ($\Delta1$). Le procédé comprend une formation d'une deuxième couche de résine photosensible (30), une exposition de cette couche à un deuxième rayonnement d'insolation (R2) au travers d'un deuxième masque (200), et un développement. Les masques sont configurés pour permette la formation d'un ensemble de deuxièmes structures (35) présentant chacune une hauteur comprise dans une deuxième gamme de hauteurs ($\Delta2$) disjointe de la première gamme de hauteurs ($\Delta1$).

FIG. 3E

EP 4 764 703 A1

**Description**

## DOMAINE TECHNIQUE

La présente invention concerne le domaine de la photolithographie, plus précisément celui de la lithographie à échelle de gris ou en nuance de gris, couramment désigné par l'expression anglais « grayscale lithography ». Elle se rapporte notamment à la fabrication de structures comprenant des éléments de différentes hauteurs.

## ETAT DE LA TECHNIQUE

La lithographie à échelle de gris est une technique de photolithographie permettant la réalisation de microstructures à trois dimensions (3D) en une unique étape de lithographique et de développement. Elle est particulièrement utilisée dans la fabrication de microéléments optiques, de MEMS (de l'anglais « microelectromechanical systems », en français microsystèmes électromécaniques), de MOEMS (de l'anglais « microoptoelectromechanical systems », en français microsystèmes optoélectromécaniques), de dispositifs microfluidiques ou encore de surfaces texturées.

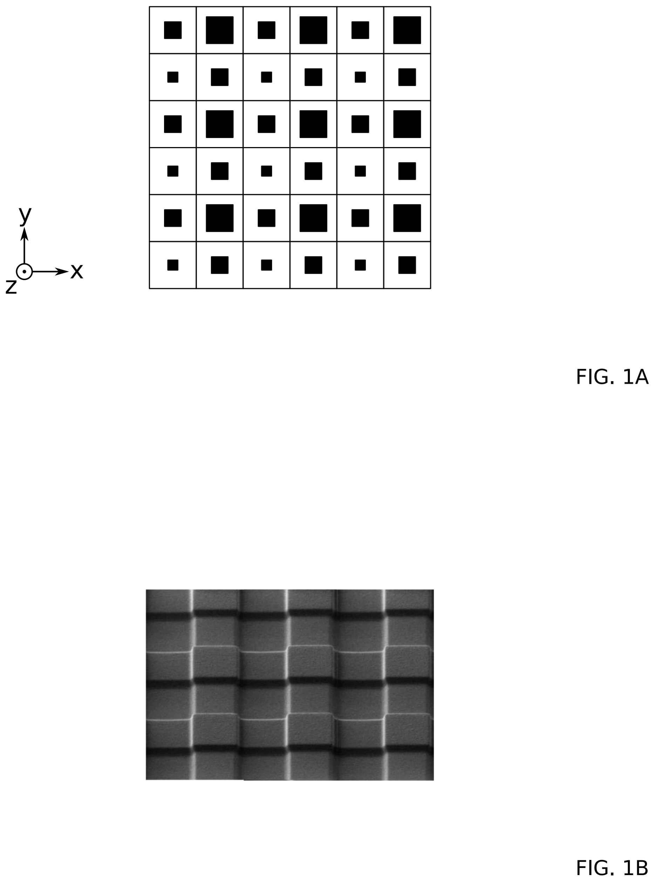

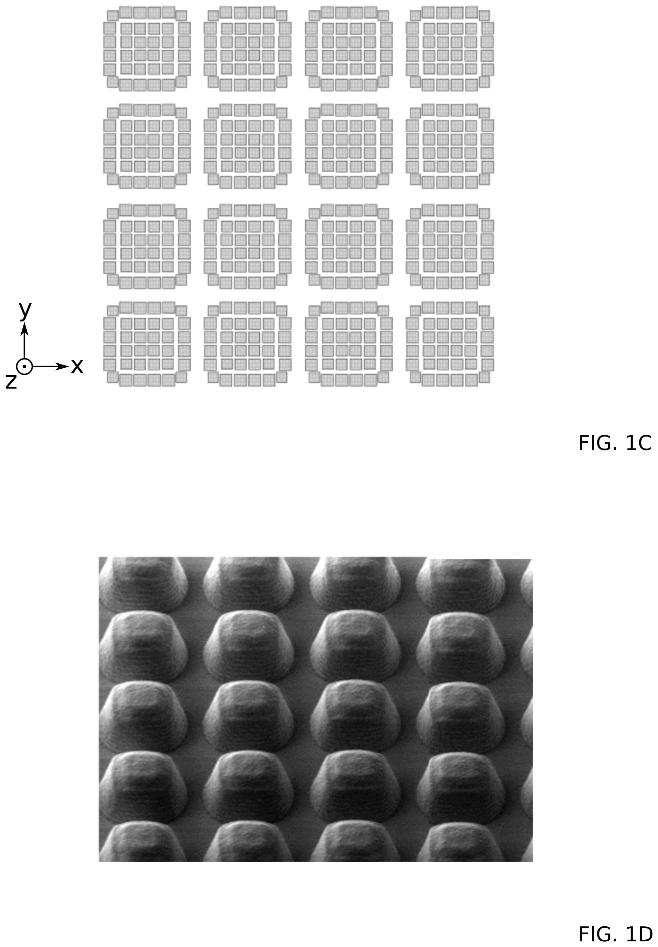

Cette technique repose sur le fait de faire varier l'épaisseur selon une dimension Z sur laquelle une résine photosensible est insolée en modulant dans l'espace la dose d'ultra-violet (UV) reçue par la résine. Une fois les portions insolées développées, la résine présente une structuration 3D (vues au microscope électronique à balayage (MEB) représentées aux figures 1B et 1D) et peut par exemple servir de moule pour la fabrication de microstructures 3D.

La dose d'ultra-violet reçue localement par la résine peut notamment être modulée en jouant sur les dimensions et le positionnement de zones opaques présentes sur le masque de lithographie (figures 1A et 1C). Ces zones opaques sont typiquement réalisées par dépôt de chrome sur un masque de verre ou quartz.

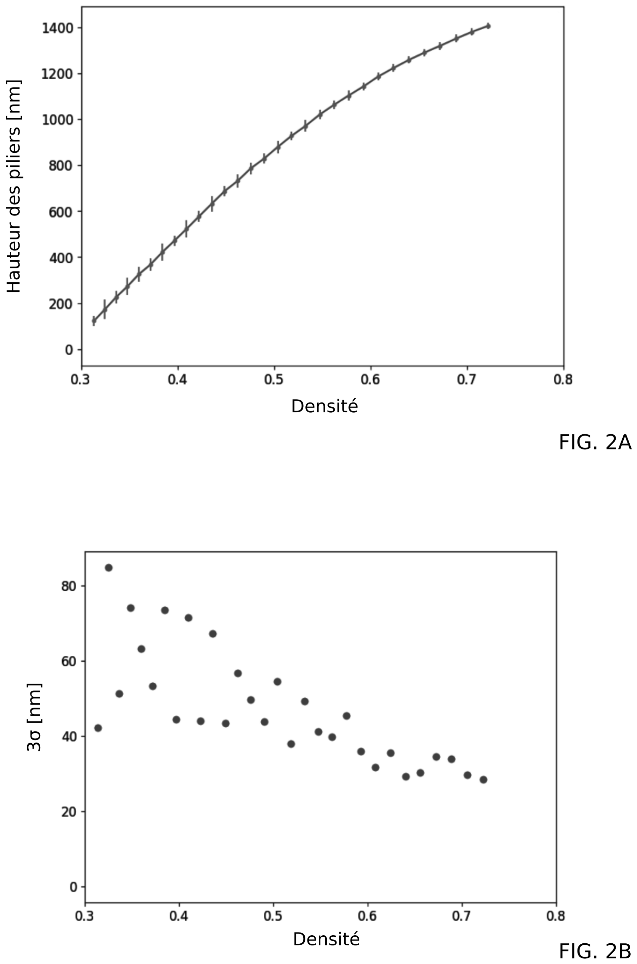

La lithographie à échelle de gris permet ainsi d'obtenir des microstructures 3D présentant une hauteur caractéristique allant d'une centaine de nanomètres à quelques centaines de micromètres. Cependant, la précision de la hauteur en chaque point de la microstructure est très dépendante de la variabilité de fabrication du masque et de la variabilité du procédé. La variabilité de la hauteur finale de la microstructure est d'autant plus forte que la densité de motifs au niveau du masque est faible, comme l'illustrent les figures 2A et 2B. Ces figures sont des résultats expérimentaux obtenus pour une couche de résine d'une épaisseur initiale de 1,6 $\mu$m, dans laquelle des piliers de différentes ont été formés. Sur la figure 2A, il apparaît clairement que les barres d'erreur, proportionnelles à trois fois l'écart-type ($3\sigma$), sont plus importantes que pour des densités plus élevées. La figure 2B, qui recense la valeur de $3\sigma$ pour différentes valeurs de densité, montre également cette tendance. Une explication à ce phénomène est que les régions de la résine exposée au travers de zones du masque à faible densité de motifs reçoivent une dose d'insolation supérieure à aux autres régions. Ces régions interagissent en conséquence plus longtemps avec l'agent de développement, ce qui peut expliquer une forte imprécision sur la hauteur des structures finales formées dans ces régions.

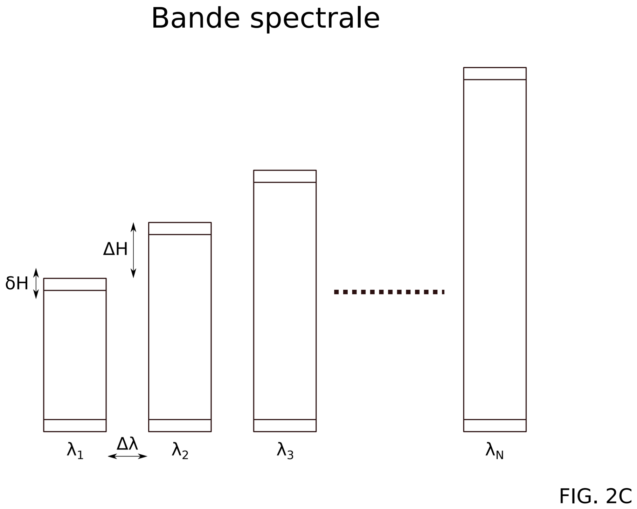

La variabilité de la hauteur des structures formées est très défavorable et limite les applications de la photolithographie à échelle de gris pouvant être envisagées. Par exemple, certains dispositifs optoélectroniques peuvent aujourd'hui difficilement voire ne peuvent pas être fabriqués par un procédé de photolithographie à échelle de gris. Les applications nécessitant une signature spectrale à différentes longueurs d'onde par exemple, comme les capteurs Fabry-Perot, requièrent un contrôle très précis de la hauteur des cavités associées à chaque longueur d'onde. Si l'on considère le dimensionnement des différents canaux associés à autant de longueurs d'ondes au sein d'une cavité Fabry-Perot (voir figure 2C) : pour une bande spectrale (en anglais « spectral range ») R souhaitée et un nombre N de canaux donné, la différence $\Delta\lambda$ entre les longueurs d'onde d'un canal à l'autre est $\Delta\lambda$=R/N et la différence $\Delta$H entre les hauteurs de canaux d'un canal à l'autre est de $\Delta$H=$\Delta\lambda$/2n, avec n l'indice de réflexion du matériau de la cavité. Si l'on souhaite par exemple une bande spectrale allant de 400 nm à 1000 nm ($\Delta\lambda$=700nm) avec N=32 et n=1,5, cela conduit à $\Delta$H=7,3nm. La hauteur de la plus petite cavité (pour $\lambda$=400nm) serait d'environ 133nm et celle de la plus grande cavité (pour $\lambda$=1100nm), de 366nm. Il apparaît qu'une telle précision sur des hauteurs de cavités aussi variées, notamment à partir d'une épaisseur courante de résine initiale d'environ 1,5 $\mu$m, est inatteignable avec les méthodes actuelles de photolithographie à échelle de gris.

Un existe donc un besoin d'une solution permettant de réaliser des structures de différentes tailles avec une bonne précision par photolithographie à échelle de gris.

## RESUME

Pour atteindre cet objectif, selon un premier aspect de l'invention concerne un procédé de lithographie en échelle de gris comprenant :

a. une fourniture d'un substrat présentant une face supérieure s'étendant principalement dans un plan horizontal, le substrat étant recouvert d'une première couche de résine photosensible,
b. une exposition de la première couche de résine photosensible à un premier rayonnement d'insolation au travers d'un premier masque puis un développement de la première couche de résine photosensible, le premier masque étant configuré pour qu'une fois la première couche de résine développée, celle-ci présente un ensemble de premières structures présentant chacune une hauteur comprise dans une première gamme de hauteurs, la hauteur des premières structures étant mesurée selon une direction dite verticale perpendiculaire au plan horizontal,

c. une formation sur la face supérieure du substrat d'une deuxième couche de résine photosensible,

d. une exposition de la deuxième couche de résine photosensible à un deuxième rayonnement d'insolation au travers d'un deuxième masque et un développement de la deuxième couche de résine photosensible, le premier masque et le deuxième masque étant configurés pour que le développement de la deuxième couche de résine permette la formation d'un ensemble de deuxièmes structures présentant chacune une hauteur comprise dans une deuxième gamme de hauteurs disjointe de la première gamme de hauteurs, la hauteur des deuxièmes structures étant mesurée selon la direction verticale, les premières structures et les deuxièmes structures se trouvant dans des zones distinctes en projection dans le plan horizontal. Le premier masque et le deuxième masque sont par ailleurs configurés pour qu'au sein de l'ensemble de premières structures, au moins deux premières structures présentent des hauteurs distinctes, et pour qu'au sein de l'ensemble de deuxième structures, au moins deux deuxièmes structures présentent des hauteurs distinctes

En procédant comme le propose l'invention, il est possible, lorsque l'on souhaite former un ensemble de structures présentant des hauteurs variées, comme c'est le cas dans beaucoup de dispositifs optoélectroniques, de tout d'abord former à l'aide du premier masque un premier ensemble de structures présentant les plus petites hauteurs. On peut ensuite, à l'aide de la deuxième couche de résine et du deuxième masque, former des structures présentant des hauteurs plus importantes. Il est entendu qu'il n'est pas obligatoire de former les structures des plus petites aux plus grandes, les groupes de structures de différentes tailles peuvent être formées dans n'importe quel ordre.

En procédant ainsi de façon séquentielle, à l'aide de deux étapes de photolithographie, on évite d'avoir à former simultanément des structures présentant des hauteurs très différentes les unes des autres. Dans le cas d'une unique couche de résine dédiée à la formation de toutes les structures, il est nécessaire de procéder à un retrait de matière sur une très grande profondeur pour former les structures les plus petites. Le procédé selon l'invention permet de s'affranchir de cela, puisque les plus petites structures peuvent être formées à partir d'une couche de résine dont la hauteur ne doit pas nécessairement permettre la confection des structures les plus grandes.

Ainsi, le procédé selon l'invention permet de libérer les contraintes sur le masque de lithographie ainsi que sur les conditions du procédé. En conséquence, les erreurs en lien avec ces deux paramètres s'en retrouve limitées. Les hauteurs effectives des structures obtenues par le procédé selon l'invention se rapprochent beaucoup plus des valeurs cibles par rapport aux procédés de l'art antérieur.

En outre, il est possible, selon un mode de réalisation de l'invention, de conserver une couche résiduelle de la première couche de résine, qui fera partie des deuxièmes structures formées lors de la deuxième étape de lithographie. En utilisant l'épaisseur de la couche résiduelle pour former les deuxièmes structures, on limite l'épaisseur requise de la deuxième couche de résine. Cela permet de réaliser une étape de lithographie dans une couche de résine plus fine, ce qui est là encore profitable à la précision sur la hauteur des structures.

Le procédé selon l'invention permet ainsi de limiter simultanément l'impact de la variabilité sur le masque et de la variabilité du procédé. Cela se traduit par une nette amélioration de la précision de fabrication par rapport aux procédés de photolithographie existants.

Un deuxième objet de la présente invention concerne une utilisation du procédé selon le premier aspect de l'invention dans la fabrication d'un dispositif photonique pris parmi : un filtre multispectral, un réseau de phase, un imageur, un coupleur.

Les avantages procurés par le procédé selon le premier aspect de l'invention s'appliquent mutatis mutandis à cette utilisation.

## BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

Les figures 1A à 1D représentent des masques de lithographie à échelle de gris et des vues au microscope électronique à balayage de résines insolées à travers ces masques puis développées. Les figures 1A et 1B concernent la fabrication de structures 3D présentant des plateaux à différentes hauteurs. Les figures 1C et 1D concernent la fabrication de microlentilles 3D présentant une forme de coupole.

La figure 2A est un graphique illustrant la hauteur de piliers obtenus par photolithographie à échelle de gris à partir de différentes densités de motifs sur le masque, ainsi que l'erreur sur cette hauteur.

La figure 2B illustre l'erreur sur la hauteur de piliers obtenus par photolithographie à échelle de gris à partir de différentes densités de motifs sur le masque.

La figure 2C illustre le dimensionnement des différents canaux associés à autant de longueurs d'ondes au sein d'une cavité Fabry-Perot.

Les figures 3A à 3E illustrent un premier mode de réalisation du procédé selon l'invention, dans lequel les deuxièmes structures sont entièrement formées dans la deuxième couche de résine.

Les figures 4A à 4E illustrent un deuxième mode de réalisation du procédé selon l'invention, dans lequel les deuxièmes structures sont formées par une couche résiduelle de la première couche de résine et par la deuxième couche de résine.

Les figures 5A à 5F illustrent un troisième mode de réalisation du procédé selon l'invention, dans lequel la deuxième étape d'insolation est réalisée au travers du premier masque ayant subi une translation relative au substrat par rapport à la première étape d'insolation.

Les figures 6A à 6D illustrent la possibilité d'utiliser la présente invention pour fabriquer un coupleur photonique.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :

Selon un exemple préféré, le premier masque et le deuxième masque sont configurés pour que la première gamme de hauteurs et la deuxième gamme de hauteurs s'étendent chacune sur une plage inférieure ou égale à 300 nm, de préférence inférieure ou égale à 200 nm, de préférence inférieure ou égale à 100 nm. Ainsi, chaque étape de lithographie est dédiée à la réalisation de structures dont les différentes hauteurs se trouvent dans une gamme restreinte. Cela permet d'améliorer la précision sur la hauteur des structures.

Selon un exemple préféré, le premier masque et le deuxième masque sont configurés de sorte que les hauteurs des premières structures sont inférieures aux hauteurs des deuxièmes structures.

Selon un mode de réalisation préféré, le procédé comprend en outre, après l'exposition et le développement de la première couche de résine photosensible et avant la formation de la deuxième couche de résine photosensible, un durcissement de la première couche de résine photosensible.

Selon un mode de réalisation, le premier masque présente des zones transparentes au premier rayonnement d'insolation, de manière à ce que le développement de la première couche de résine provoque, en dehors des premières structures, son retrait sur toute sa hauteur selon la direction verticale.

Selon un mode de réalisation, le premier masque est configuré pour qu'une fois la première couche de résine développée, celle-ci présente, en dehors des premières structures, une couche résiduelle, et chacune des deuxièmes structures comprend une partie de la couche résiduelle. **En** conservant une couche résiduelle, on minimise la topographie de surface créée par la première couche de résine développée. Le dépôt de la deuxième couche de résine se fait donc sur une surface présentant une topographie de surface plus faible. La rugosité transférée à la surface supérieure de la deuxième couche de résine s'en retrouve limitée. Ce mode de réalisation permet ainsi de minimiser la rugosité de surface des deuxièmes structures.

Selon un exemple, le premier masque présente des zones opaques au premier rayonnement d'insolation, de manière à ce que la couche résiduelle présente au moins localement une hauteur égale à une hauteur de la première couche de résine avant insolation et développement, la hauteur de la couche résiduelle et la hauteur de la première couche de résine étant mesurée selon la direction verticale.

Selon un exemple, le deuxième masque est le premier masque ayant subi une translation relativement au substrat.

Selon un mode de réalisation, la deuxième couche photosensible est déposée sur les premières structures, et le deuxième masque présente des zones transparentes au deuxième rayonnement d'insolation, de manière à ce que le développement de la deuxième couche de résine provoque la mise au jour des premières structures.

Selon un exemple, les au moins deux premières structures présentant des hauteurs distinctes présentent une différence de hauteur, dite première différence de hauteur, supérieure ou égale à 20 nm.

Selon un exemple, les au moins deux deuxièmes structures présentant des hauteurs distinctes présentent une différence de hauteur, dite deuxième différence de hauteur, supérieure ou égale à 20 nm.

Dans le cadre de la présente invention, on qualifie de résine un matériau organique ou organo-minéral pouvant être mis en forme par une exposition à un faisceau d'électrons, de photons, de rayons X, un faisceau de lumière dans la gamme des ultraviolets, des extrêmes ultraviolets (EUV) ou des ultraviolets profonds (Deep UV) typiquement dans la gamme de longueurs d'onde de 193 nm à 248 nm, les raies d'émissions d'une lampe mercure, soit : 365 nm pour la I line, 435 nm pour la G line et 404 nm pour la H line.

L'invention s'applique aussi bien aux résines positives, c'est-à-dire dont la partie exposée devient soluble au révélateur et où la partie non exposée reste insoluble, qu'aux résines négatives, c'est-à-dire dont la partie non exposée devient soluble au révélateur et où la partie exposée reste insoluble.

Le contraste d'une résine, couramment noté $\gamma$, traduit l'efficacité du comportement désigné dans la littérature comme « à seuil » de la résine. Plus le contraste est grand, plus une faible variation de dose est nécessaire pour que la résine passe d'un état dans lequel elle ne peut pas être développée à un état dans lequel elle peut être développée (ou inversement pour une résine négative). La valeur du contraste y d'une résine, qu'elle soit de tonalité positive ou négative, est généralement déterminée par la pente de la courbe selon l'équation suivante : $\frac{e}{e_0} = \gamma ln\left(\frac{D_0}{D}\right)$, où e est l'épaisseur du film de résine après exposition et développement, $e_0$ est l'épaisseur du film de résine initial, D est la dose d'exposition appliquée et $D_0$ est la dose à laquelle toute l'épaisseur du film est développée.

On entend par « nature » d'un matériau tel qu'une résine sa composition chimique, c'est-à-dire la nature et la proportion des espèces constituant le matériau. Deux couches sont considérées comme faites d'une même résine si elles présentent la même composition chimique.

Dans la présente description, on qualifie de dose une quantité d'énergie reçue par une résine par unité de surface. Cette énergie peut être sous forme de photons (photolithographie) pour une résine photosensible. Elle est alors le produit de l'intensité du rayonnement lumineux incident (généralement exprimée en Watt/m$^2$) et de la durée d'exposition (exprimée en secondes). La dose est alors habituellement exprimée en Joules par m$^2$, ou plus souvent en milli Joules (mJ) par cm$^{-2}$ ($10^{-4}$ m$^2$) ou encore en mJ/m$^2$. Cette énergie peut également être sous forme d'électrons (lithographie électronique) pour une résine électrosensible. La dose est alors habituellement exprimée en Coulombs par m2, ou plus souvent en micro Coulombs ($\mu$C) par cm$^{-2}$ ($10^{-2}$ m$^2$) soit en $\mu$C/m$^2$.

La densité D de motifs à imposer au niveau du masque pour obtenir une hauteur de structure donnée peut être obtenue par les équations suivantes :

$$h_{résine} = (h_0 - h_{dark}) - \left[e^{e_1 + e_2*m + e_3*m^2} + e_4 * dose\right]$$

$$m = e^{-C*dose}$$

$$dose = D_{src}(1-D)^2$$

Avec : $h_{résine}$ la hauteur de structure souhaitée, $h_{dark}$ la hauteur d'érosion de la résine sans exposition, « dose » la dose d'exposition et $h_0$ l'épaisseur initiale de résine après dépôt et avant exposition/développement. $e_1$, $e_2$, $e_3$ et $e_4$ sont des paramètres pouvant être obtenu par extraction à partir de la courbe de contraste. C est le coefficient de Dill de la résine, généralement fourni par le fabricant de résine.

On entend par un paramètre « sensiblement égal/supérieur/inférieur à » une valeur donnée que ce paramètre est égal/supérieur/inférieur à la valeur donnée, à plus ou moins 20 %, voire 10 %, voire 5% près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan horizontal XY. Ainsi, une couche présente typiquement une épaisseur selon la direction dite verticale Z, lorsqu'elle s'étend principalement le long du plan horizontal XY. Les termes relatifs « sur », « sous », « sous-jacent » se réfèrent préférentiellement à des positions prises selon la direction verticale Z.

Le procédé selon l'invention va maintenant être décrit plus en détails en référence aux figures.

Une première étape du procédé comprend la fourniture d'un substrat 10. Ce substrat présente une face supérieure 11 s'étendant principalement selon le plan horizontal XY. Le substrat 10 peut par exemple être pris parmi un substrat en verre, un substrat en silicium ou encore un substrat avec des composants CMOS (de l'anglais « Complementary metal oxide semi-conductor »).

Le substrat 10 est recouvert d'une première couche de résine photosensible 20. Avantageusement, la première couche de résine 20 se trouve au contact de la face supérieure 11 du substrat 10. La première couche de résine 20 présente une épaisseur $e_{20}$ mesurée selon la direction verticale Z, perpendiculaire au plan horizontal XY. $e_{20}$ est typiquement inférieure ou égale à 1$\mu$m, par exemple comprise entre 200 nm et 1$\mu$m, par exemple environ égale à 500 nm.

Une deuxième étape du procédé comprend l'insolation de la première couche de résine 20 au travers d'un premier masque 100. Cette étape d'insolation est réalisée par exposition de la première couche de résine 20 à un premier rayonnement incident $R_1$ au travers du premier masque 100. On procède ensuite au développement de la première couche de résine photosensible 20. Les caractéristiques du premier masque 100 seront décrites plus avant, en fonction des modes de réalisation.

Cette deuxième étape permet la formation de premières structures 25 dans la première couche de résine 20. Ces premières structures 25 présentent chacune une hauteur $h_{251}$, $h_{252}$, $h_{253}$, $h_{254}$ mesurée selon la direction verticale Z. Lorsque la première couche de résine 20 se trouve au contact du substrat 10, la hauteur des première structures 25 est mesurée à partir de la face supérieure 11 du substrat 10.

La hauteur de chaque première structure 25 est comprise dans une première gamme de hauteurs notée $\Delta_1$. Ainsi, le premier masque 100 est dédié à la fabrication de structures dont la hauteur se trouve dans cette première gamme $\Delta_1$.

La hauteur de chaque première structure 25 est typiquement supérieure ou égale à 50 nm.

Au sein de l'ensemble de premières structures 25, au moins deux premières structures 25 présentent des hauteurs différentes. La différence de hauteur entre ces au moins deux premières structures 25 (pouvant être désignée « première différence de hauteur ») est typiquement supérieure ou égale à 20 nm et/ou inférieure ou égale à 50 nm. La première différence de hauteur est par exemple sensiblement égale à 20 nm. Selon un exemple particulier, les premières structures 25 présentent toutes des hauteurs différentes (autrement dit, pour quatre premières structures 25, $h_{251}$, $h_{252}$, $h_{253}$ et $h_{254}$ ont toutes des valeurs différentes).

Avantageusement, une fois les premières structures 25 formées, on procède à un durcissement de la première couche de résine 20. Cela comprend notamment un durcissement des premières structures 25.

Une troisième étape du procédé comprend la formation d'une deuxième couche de résine photosensible 30 sur le substrat 10, plus particulièrement sur la face supérieure 11 du substrat 10. Typiquement, la deuxième couche de résine 30 recouvre les portions de la première couche de résine 20 restantes après son développement. La deuxième couche de résine 30 présente une épaisseur $e_{30}$ mesurée selon la direction verticale Z, perpendiculaire au plan horizontal XY. $e_{30}$ correspond à la hauteur maximale prise par la deuxième couche de résine. $e_{30}$ est choisir en fonction de la hauteur de la plus haute deuxième structure 35 que l'on souhaite fabriquer.

La deuxième couche de résine photosensible 30 peut être de même nature que la première couche de résine photosensible 20. Il est également possible d'employer des résines de natures différentes.

Une quatrième étape du procédé comprend l'insolation de la deuxième couche de résine 30 au travers d'un deuxième masque 200. Cette étape d'insolation est réalisée par exposition de la deuxième couche de résine 30 à un deuxième rayonnement incident $R_2$ au travers du deuxième masque 200. On procède ensuite au développement de la deuxième couche de résine photosensible 30. Les caractéristiques du deuxième masque 200 seront décrites plus avant, en fonction des modes de réalisation. De préférence, le deuxième masque 200 n'est pas l'ensemble de premières structures 25.

Cette quatrième étape permet la formation de deuxièmes structures 35. Les deuxièmes structures 35 peuvent chacune être formée entièrement par la deuxième couche de résine 30, ou bien en partie par la deuxième couche de résine 30 et en partie par la première couche de résine 20. Ces deux possibilités seront détaillées plus avant.

Les deuxièmes structures 35 présentent chacune une hauteur $h_{351}$, $h_{352}$, $h_{353}$ mesurée selon la direction verticale Z.

La hauteur de chaque deuxième structure 35 est comprise dans une deuxième gamme de hauteurs notée $\Delta_2$. Ainsi, le deuxième masque 200 (éventuellement en combinaison avec le premier masque 100) est dédié à la fabrication de structures dont la hauteur se trouve dans cette deuxième gamme $\Delta_2$. La première gamme de hauteurs $\Delta_1$ et la deuxième gamme de hauteurs $\Delta_2$ sont disjointes. Autrement dit, leur intersection est nulle.

La hauteur de chaque deuxième structure 35 est typiquement supérieure ou égale à 500 nm.

Au sein de l'ensemble de deuxièmes structures 35, au moins deux deuxièmes structures 35 présentent des hauteurs différentes. La différence de hauteur entre ces au moins deux deuxièmes structures 35 (pouvant être désignée « deuxième différence de hauteur ») est typiquement supérieure ou égale à 20 nm et/ou inférieure ou égale à 50 nm. La deuxième différence de hauteur est par exemple sensiblement égale à 20 nm. Selon un exemple particulier, les deuxièmes structures 35 présentent toutes des hauteurs différentes (autrement dit, pour trois deuxièmes structures 35, $h_{351}$, $h_{352}$ et $h_{353}$ ont toutes des valeurs différentes).

Avantageusement, une fois les deuxièmes structures 35 formées, on procède à un durcissement de la deuxième couche de résine 30. Cela comprend notamment un durcissement des deuxièmes structures 35.

Le premier rayonnement $R_1$ et le deuxième rayonnement $R_2$ auxquels sont soumis les couches de résine 20, 30 présentent chacun une direction principale sensiblement perpendiculaire au plan horizontal XY. Ces rayonnements $R_1$, $R_2$ sont typiquement des rayonnements UV (pour ultra-violet), il peut ainsi s'agir de rayonnements émettant dans une gamme de longueur d'onde allant d'environ 100 nm à environ 400 nm, par exemple 365 nm. Il peut cependant également s'agir de rayonnements présentant des longueurs d'ondes se trouvant en dehors de cette gamme. De façon générale, on peut envisager non limitativement des rayonnements émettant dans une gamme de longueur d'onde allant d'environ 90 nm à environ 500 nm. Le premier rayonnement $R_1$ et le deuxième rayonnement $R_2$ peuvent être similaires ou différents.

Idéalement, la ou les résine(s) utilisée(s) présente(nt) au moins l'une des caractéristiques suivantes :

    a. Une réponse sensiblement linéaire entre la dose de rayonnement à laquelle elle est exposée et l'épaisseur sur laquelle elle est insolée.

    b. Un contraste suffisamment faible, par exemple inférieur à 2, pour permettre la mise en oeuvre de la lithographie en échelle de gris, mais suffisamment élevé, par exemple supérieur à 1, pour éviter des temps d'exposition trop importants. Avantageusement, le contraste est compris entre 1,1 et 1,5.

    c. De bonnes propriétés filmogènes, garanties par exemple par la présence d'un agent filmogène dans sa composition.

    d. Une faible inhibition de la dissolution.

On peut notamment citer comme exemples de résines utilisables dans le contexte de l'invention les résines, produites par la société Micro Resist Technology portant les références commerciales ma-P 1215G, ma-P 1225G et ma-P 1275G.

Le durcissement des résines peut être réalisé par voie thermique ou voie chimique.

Le premier masque 100 et le deuxième masque 200 présentent des zones transparentes et des zones opaques.

Les zones transparentes correspondent à des régions du masque 100, 200 dont la composition est transparente au rayonnement d'insolation $R_1$, $R_2$, tandis que les zones opaques correspondent à des régions du masque 100, 200 dont la composition est opaque au rayonnement d'insolation $R_1$, $R_2$. Une zone est par exemple considérée comme opaque lorsqu'elle arrête au moins 90% du rayonnement incident $R_1$, $R_2$. Une zone est considérée comme transparente lorsqu'elle transmet au moins 60% du rayonnement incident $R_1$, $R_2$.

Par exemple, le masque peut être un masque de verre avec des dépôts de chrome. Les zones opaques correspondent alors aux zones du masque 100, 200 où du chrome a été déposé, tandis que les zones transparentes correspondent aux zones restées exemptes de chrome.

Selon le principe de la lithographie à échelle de gris, pour une région donnée du masque 100, 200, la densité surfacique D des zones opaques au sein de cette région détermine la dose de rayonnement reçue par la région de la couche de résine 20, 30 sous-jacente et donc, par conséquent, l'épaisseur e sur laquelle cette région de la couche de résine 20, 30 est insolée par le rayonnement $R_1$, $R_2$. Cette densité D est typiquement modulée d'une région à l'autre du masque 100, 200 de façon à moduler spatialement l'épaisseur insolée dans la couche de résine 20, 30.

Pour une région donnée du masque, la densité surfacique D des zones opaques est le ratio entre la surface de la région occupée par les zones opaques et la surface totale de la région. Ces surfaces peuvent par exemple être évaluées au niveau d'une face inférieure du masque 100, 200 se trouvant en regard de la couche de résine 20, 30 lors de l'insolation. C'est typiquement sur cette face que sont réalisés les dépôts de matière (par exemple de chrome) formant les zones opaques.

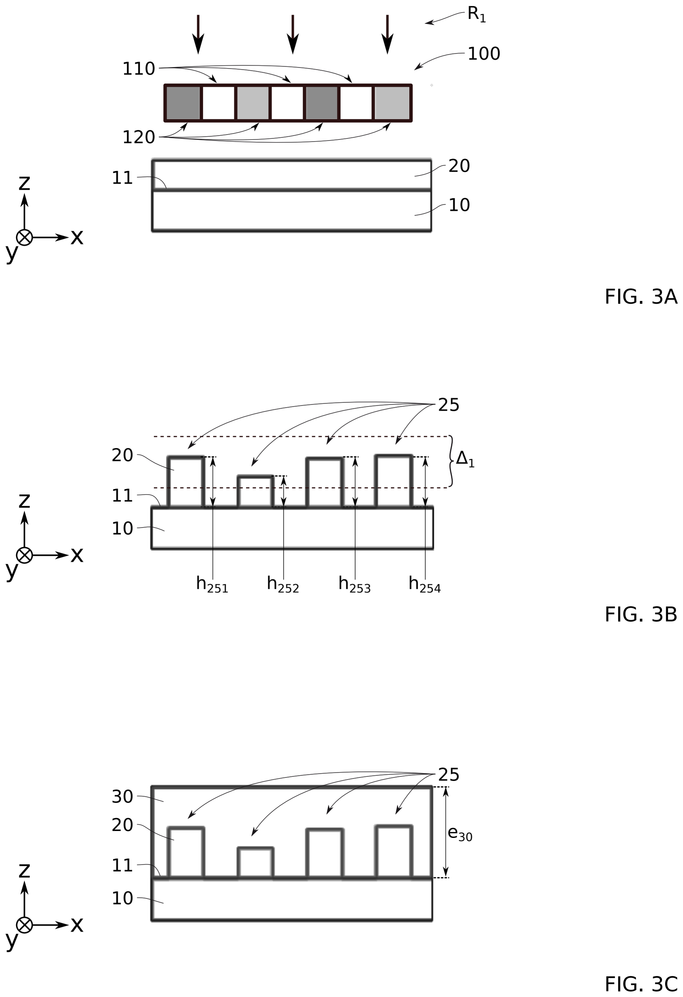

Un premier mode de réalisation du procédé selon l'invention va maintenant être décrit en référence aux figures 3A à 3E.

La figure 3A illustre la fourniture du substrat 10 surmonté de la première couche de résine 20 ainsi que l'insolation de la première couche de résine 20 par le premier rayonnement $R_1$ au travers du premier masque 100.

Le passage de la figure 3A à la figure 3B illustre le développement de la première couche de résine 20. On obtient ainsi une pluralité de premières structures 25 formées dans la première couche de résine 20.

Comme illustré, la hauteur $h_{251}$, $h_{252}$, $h_{253}$, $h_{254}$ de chaque première structure 25 se trouve dans la première gamme $\Delta_1$. Comme illustré, les hauteurs $h_{251}$, $h_{252}$, $h_{253}$, $h_{254}$ des premières structures 25 ne sont pas toutes identiques. Comme indiqué précédemment, au moins deux sont différentes entre elles. Sur l'exemple illustré, les premières structures 25 présentent toutes des hauteurs différentes.

Avantageusement, le premier masque 100 employé dans ce mode de réalisation comprend des zones transparentes 110. Ces zones transparentes 110 permettent de retirer localement la première couche de résine 20 sur toute sa hauteur. La face supérieure 11 du substrat 10 est ainsi de préférence localement exposée entre les premières structures 25 (voir figure 3B).

Le premier masque 100 comprend par ailleurs des zones 120 ni entièrement transparentes, ni entièrement opaques, dites zones intermédiaires 120, dédiées à la formation des premières structures 25 avec des hauteurs distinctes, selon le principe de la lithographie à échelle de gris.

Avantageusement, on procède à ce stade du procédé à un durcissement de la première couche de résine 20, c'est-à-dire ici à un durcissement des premières structures 25.

La figure 3C illustre le dépôt de la deuxième couche de résine photosensible 30 sur le substrat 10. Comme illustré, la deuxième couche de résine 30 s'étend sur les premières structures 25 et directement au contact de la face supérieure 11 du substrat 10 dans les zones où celle-ci a été mise à jour par insolation et développement de la première couche de résine 20.

La deuxième couche de résine 30 forme ainsi une encapsulation des premières structures 25.

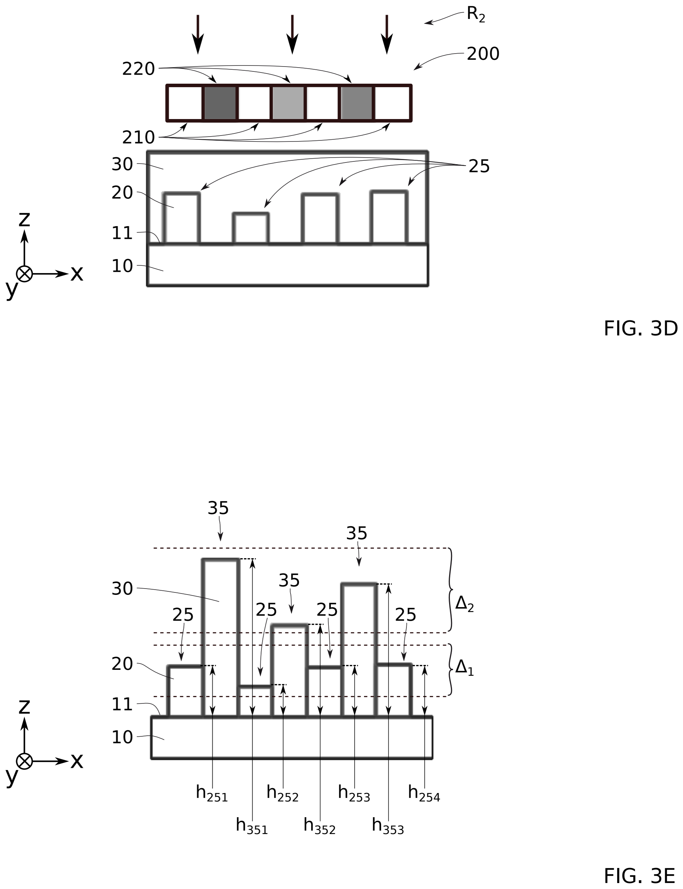

La figure 3D illustre l'insolation de la deuxième couche de résine 30 par le deuxième rayonnement $R_2$ au travers du deuxième masque 200.

Le passage de la figure 3D à la figure 3E illustre le développement de la deuxième couche de résine 30. On obtient ainsi une pluralité de deuxièmes structures 35 formées dans la deuxième couche de résine 30.

Comme illustré, la hauteur $h_{351}$, $h_{352}$, $h_{353}$, $h_{354}$ de chaque deuxième structure 35 se trouve dans la deuxième gamme $\Delta_2$. Dans l'exemple illustré, la deuxième gamme $\Delta_2$ comprend des valeurs supérieures à la première gamme $\Delta_1$. Comme illustré, les hauteurs $h_{351}$, $h_{352}$, $h_{353}$ des deuxièmes structures 35 ne sont pas toutes identiques. Comme indiqué précédemment, au moins deux sont différentes entre elles. Sur l'exemple illustré, les deuxièmes structures 35 présentent toutes des hauteurs différentes.

Avantageusement, le deuxième masque 200 employé dans ce mode de réalisation comprend des zones transparentes 210. Ces zones transparentes 210 permettent de retirer localement la deuxième couche de résine 30 sur toute sa hauteur. Avantageusement, lors de l'insolation de la deuxième couche de résine 30, ces zones transparents 210 se trouvent à l'aplomb des premières structures 25. Cela permet de mettre au jour les premières structures 25 (voir figure 3E). Les premières structures 25 ayant de préférence au préalable subi un durcissement, elles ne sont pas altérées par l'étape d'insolation et développement subie par la deuxième couche de résine 30 sus-jacente.

Le deuxième masque 200 comprend par ailleurs des zones 220 ni entièrement transparentes, ni entièrement opaques, dites zones intermédiaires 220, dédiées à la formation des deuxièmes structures 35 avec des hauteurs distinctes, selon le principe de la lithographie à échelle de gris.

De préférence, dans ce mode de réalisation, lorsque l'on considère chacun parmi le premier masque 100 et le deuxième masque 200 dans la même position d'insolation des couches de résine 20, 30, les zones transparentes 110 du premier masque 100 se trouvent au même endroit que les zones intermédiaires 220 du deuxième masque 200. Par ailleurs, de préférence, les zones transparentes 210 du deuxième masque 200 se trouvent au même endroit que les zones intermédiaires 120 du premier masque 100.

Autrement dit, en superposant le premier masque 100 et le deuxième masque 200, on a alors de préférence, en projection dans le plan horizontal XY :

a. une superposition des zones transparentes 110 du premier masque 100 et des zones intermédiaires 220 du deuxième masque 200, et/ou

b. une superposition des zones transparentes 210 du deuxième masque 200 et des zones intermédiaires 120 du premier masque 100.

Il est entendu que les zones intermédiaires 120, 220 de chaque masque 100, 200 peuvent pour certaines correspondre à des zones opaques, si l'on souhaite que la structure formée après développement 25, 35 présente une hauteur égale à la couche de résine 20, 30 déposée.

Ainsi, dans ce mode de réalisation, chaque masque 100, 200 est entièrement dédié à la formation de structures 25, 35 dans une gamme de hauteurs $\Delta_1$, $\Delta_2$.

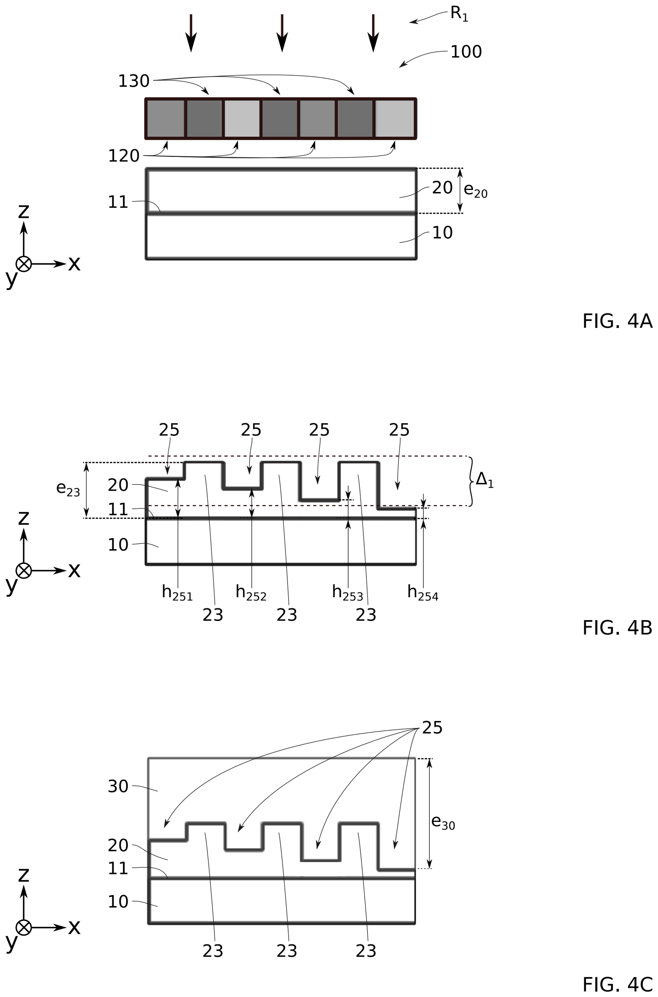

Un deuxième mode de réalisation du procédé selon l'invention va maintenant être décrit en référence aux figures 4A à 4E.

La figure 4A illustre la fourniture du substrat 10 surmonté de la première couche de résine 20 ainsi que l'insolation de la première couche de résine 20 par le premier rayonnement $R_1$ au travers du premier masque 100.

Le passage de la figure 4A à la figure 4B illustre le développement de la première couche de résine 20. Comme dans le premier mode de réalisation, on obtient ainsi une pluralité de premières structures 25 formées dans la première couche de résine 20. Là aussi, la hauteur $h_{251}$, $h_{252}$, $h_{253}$, $h_{254}$ de chaque première structure 25 se trouve dans la première gamme $\Delta_1$. Comme illustré, les hauteurs $h_{251}$, $h_{252}$, $h_{253}$, $h_{254}$ des premières structures 25 ne sont pas toutes identiques. Comme indiqué précédemment, au moins deux sont différentes entre elles. Sur l'exemple illustré, les premières structures 25 présentent toutes des hauteurs différentes.

Avantageusement, le premier masque 100 employé dans ce mode de réalisation comprend des zones opaques 130. Ces zones opaques 130 permettent de conserver localement toute la hauteur de la première couche de résine 20. Après développement de la première couche de résine 20, on obtient ainsi une couche résiduelle 23 présentant une épaisseur $e_{23}$ égale à $e_{20}$.

Selon un autre exemple, à la place de zones totalement opaques 130, il est possible d'employer des zones ni entièrement opaques, ni entièrement transparentes. Ces zones sont alors configurées pour que l'insolation et le développement de la première couche de résine 20 retire la résine sur une partie de sa hauteur seulement. Après développement de la première couche de résine 20, on obtient ainsi une couche résiduelle 23 présentant une épaisseur $e_{23}$ comprise entre 0 (exclu, ou alors l'épaisseur nulle est prise localement) et $e_{20}$.

Dans les deux cas, on forme une couche résiduelle 23 qui servira à la formation des deuxièmes structures 35 (voir plus avant).

Il est entendu que la couche résiduelle 23 ne présente pas nécessairement une épaisseur uniforme. Il est notamment possible de ne pas laisser localement de couche résiduelle 23. Il est possible de former la couche résiduelle 23 à l'aide de zones dans le premier masque 100 présentant des densités de zones opaques différentes. Former une couche résiduelle 23 présentant une hauteur non uniforme peut permettre d'atteindre des hauteurs de deuxièmes structures 35 plus variées.

Comme dans le premier mode de réalisation, le premier masque 100 comprend par ailleurs des zones 120 ni entièrement transparentes, ni entièrement opaques, dites zones intermédiaires 120, dédiées à la formation des premières structures 25 avec des hauteurs distinctes, selon le principe de la lithographie à échelle de gris.

Avantageusement, on procède à ce stade du procédé à un durcissement de la première couche de résine 20, c'est-à-dire ici à un durcissement des premières structures 25 et de la couche résiduelle 23.

La figure 4C illustre le dépôt de la deuxième couche de résine photosensible 30 sur le substrat 10. Comme illustré, la deuxième couche de résine 30 s'étend sur les premières structures 25 et sur la couche résiduelle 23.

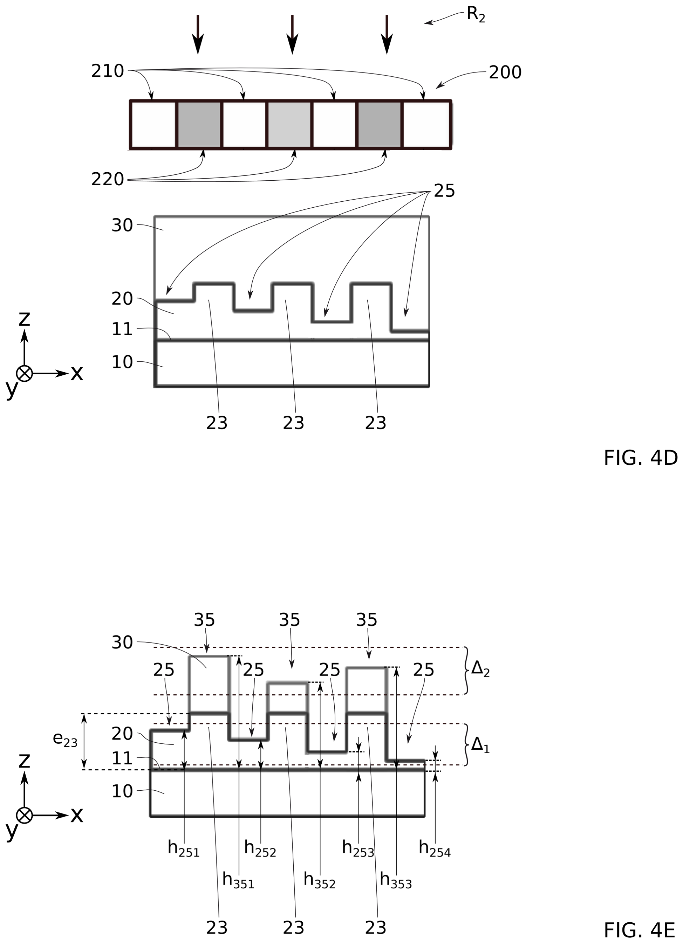

La figure 4D illustre l'insolation de la deuxième couche de résine 30 par le deuxième rayonnement $R_2$ au travers du deuxième masque 200.

Le passage de la figure 4D à la figure 4E illustre le développement de la deuxième couche de résine 30. On obtient ainsi une pluralité de deuxièmes structures 35 chacune formée par une portion de la deuxième couche de résine 30 et une portion de la couche résiduelle 23. La hauteur $h_{351}$, $h_{352}$, $h_{353}$, $h_{354}$ de chaque deuxième structure 35 est supérieure ou égale à l'épaisseur $e_{23}$ locale de la couche résiduelle 23.

Comme illustré, la hauteur $h_{351}$, $h_{352}$, $h_{353}$, $h_{354}$ de chaque deuxième structure 35 se trouve dans la deuxième gamme $\Delta_2$. Dans l'exemple illustré, la deuxième gamme $\Delta_2$ comprend des valeurs supérieures à la première gamme $\Delta_1$. Comme illustré, les hauteurs $h_{351}$, $h_{352}$, $h_{353}$ des deuxièmes structures 35 ne sont pas toutes identiques. Comme indiqué précédemment, au moins deux sont différentes entre elles. Sur l'exemple illustré, les deuxièmes structures 35 présentent toutes des hauteurs différentes.

Avantageusement, le deuxième masque 200 employé dans ce mode de réalisation comprend des zones transparentes 210. Ces zones transparentes 210 permettent de retirer localement la deuxième couche de résine 30 sur toute sa hauteur. Avantageusement, lors de l'insolation de la deuxième couche de résine 30, ces zones transparents 210 se trouvent à l'aplomb des premières structures 25. Cela permet de mettre au jour les premières structures 25 (voir figure 4E). Les premières structures 25 ayant de préférence au préalable subi un durcissement, elles ne sont pas altérées par l'étape d'insolation et développement subie par la deuxième couche de résine 30 sus-jacente.

Le deuxième masque 200 comprend par ailleurs des zones 220 ni entièrement transparentes, ni entièrement opaques, dites zones intermédiaires 220, dédiées à la formation des deuxièmes structures 35 avec des hauteurs distinctes, selon le principe de la lithographie à échelle de gris.

De préférence, dans ce mode de réalisation, lorsque l'on considère chacun parmi le premier masque 100 et le deuxième masque 200 dans la même position d'insolation des couches de résine 20, 30, les zones opaques 130 du premier masque 100 se trouvent au même endroit que les zones intermédiaires 220 du deuxième masque 200. Par ailleurs, de préférence, les zones transparentes 210 du deuxième masque 200 se trouvent au même endroit que les zones intermédiaires 120 du premier masque 100.

Autrement dit, en superposant le premier masque 100 et le deuxième masque 200, on a alors de préférence, en projection dans le plan horizontal XY :

    a. une superposition des zones opaques 130 du premier masque 100 et des zones intermédiaires 220 du deuxième masque 200, et/ou

    b. une superposition des zones transparentes 210 du deuxième masque 200 et des zones intermédiaires 120 du premier masque 100.

Il est entendu que les zones intermédiaires 120, 220 de chaque masque 100, 200 peuvent pour certaines correspondre à des zones opaques, si l'on souhaite que la structure formée après développement 25, 35 présente une hauteur égale à la couche de résine 20, 30 déposée.

Ainsi, dans ce mode de réalisation, le premier masque 100 est dédié non seulement à la formation des premières structures 25 dans la première gamme de hauteurs $\Delta_1$, mais participe également à la formation des deuxièmes structures 35 dans la deuxième gamme de hauteurs $\Delta_2$.

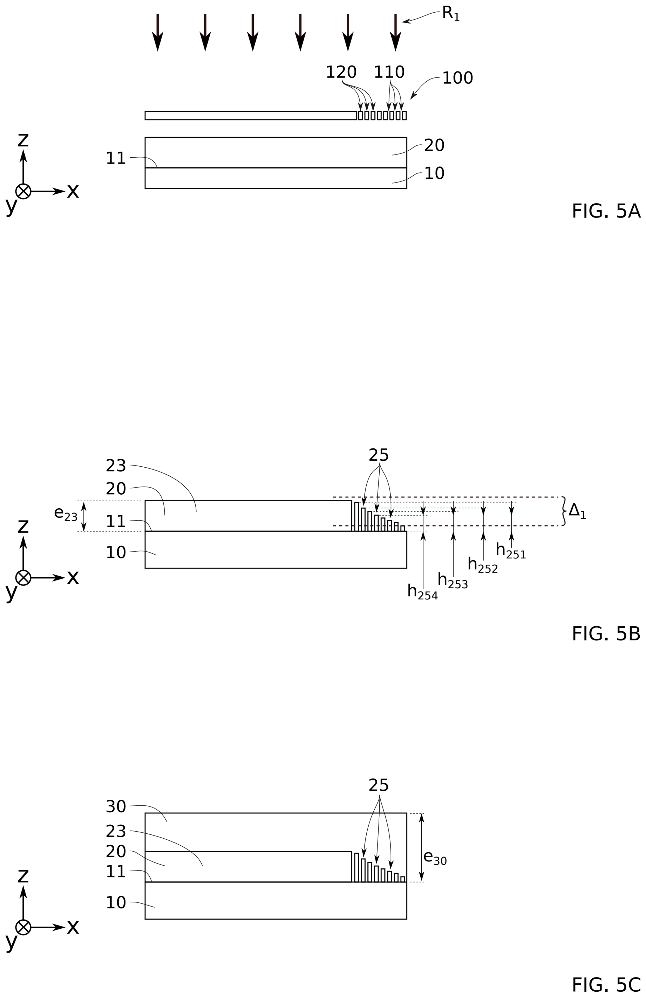

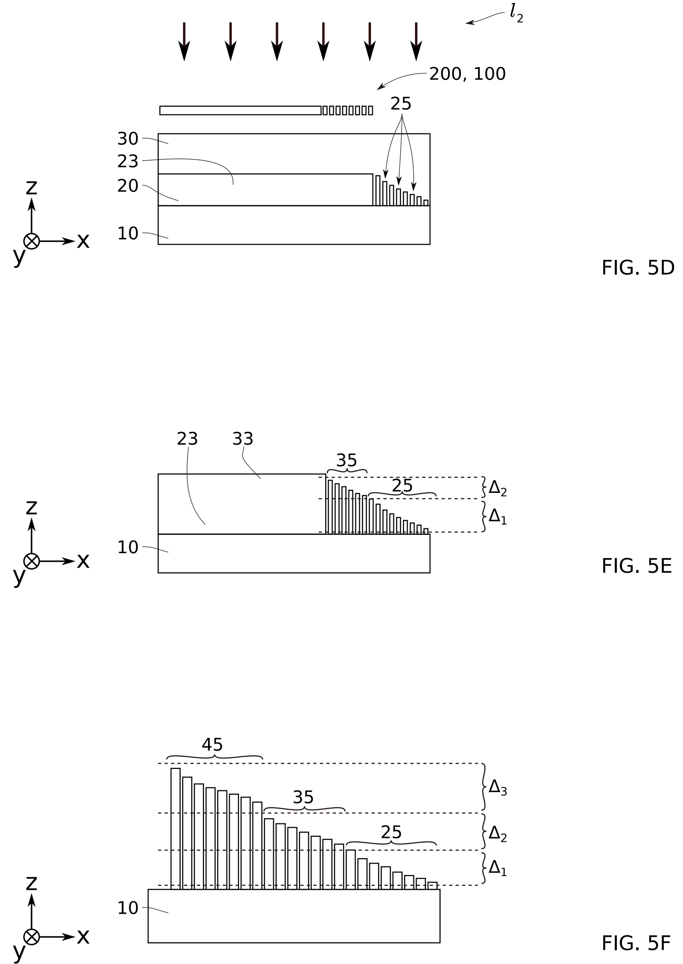

Un troisième mode de réalisation du procédé selon l'invention va maintenant être décrit en référence aux figures 5A à 5F.

Ce mode de réalisation combine les principes des deux premiers modes de réalisation.

La figure 5A illustre la fourniture du substrat 10 surmonté de la première couche de résine 20 ainsi que l'insolation de la première couche de résine 20 par le premier rayonnement $R_1$ au travers du premier masque 100.

Le passage de la figure 5A à la figure 5B illustre le développement de la première couche de résine 20. Comme dans les autres modes de réalisation, on obtient ainsi une pluralité de premières structures 25 formées dans la première couche de résine 20. Là aussi, comme illustré, la hauteur $h_{251}$, $h_{252}$, $h_{253}$, $h_{254}$ de chaque première structure 25 se trouve dans la première gamme $\Delta_1$. Comme illustré, les hauteurs $h_{251}$, $h_{252}$, $h_{253}$, $h_{254}$ des premières structures 25 ne sont pas toutes identiques. Comme indiqué précédemment, au moins deux sont différentes entre elles. Sur l'exemple illustré, les premières structures 25 présentent toutes des hauteurs différentes.

Dans ce mode de réalisation, le premier masque 100 comprend une zone opaque 130 continue. La zone opaque 23 s'étend de préférence au-dessus d'une majeure partie de la première couche de résine 20, par exemple au-dessus d'au moins la moitié de la surface de la première couche de résine 20. Cette zone opaques 130 permet de conserver localement toute la hauteur de la première couche de résine 20. Après développement de la première couche de résine 20, on obtient ainsi une couche résiduelle 23 présentant une épaisseur $e_{23}$ égale à $e_{20}$. Comme précédemment, il est possible de configurer le premier masque 100 pour que la couche résiduelle 23 présente une épaisseur $e_{23}$ comprise entre 0 (exclu, ou alors l'épaisseur nulle est prise localement) et $e_{20}$. Par ailleurs, la couche résiduelle 23 peut présenter une épaisseur non homogène.

Comme dans les autres modes de réalisation, le premier masque 100 comprend par ailleurs des zones 120 ni entièrement transparentes, ni entièrement opaques, dites zones intermédiaires 120, dédiées à la formation des premières structures 25 avec des hauteurs distinctes, selon le principe de la lithographie à échelle de gris.

De préférence, le premier masque 100 employé dans ce mode de réalisation comprend des zones transparentes 110. Ces zones transparentes 110 permettent de retirer localement la première couche de résine 20 sur toute sa hauteur. La face supérieure 11 du substrat 10 est ainsi de préférence localement exposée entre les premières structures 25 (voir figure 5B).

Avantageusement, on procède à ce stade du procédé à un durcissement de la première couche de résine 20, c'est-à-dire ici à un durcissement des premières structures 25 et de la couche résiduelle 23.

La figure 5C illustre le dépôt de la deuxième couche de résine photosensible 30 sur le substrat 10. Comme illustré, la deuxième couche de résine 30 s'étend sur les premières structures 25 et sur la couche résiduelle 23. Elle s'étend par ailleurs directement au contact de la face supérieure 11 du substrat 10 dans les zones où celle-ci a été mise à jour par insolation et développement de la première couche de résine 20.

La figure 5D illustre l'insolation de la deuxième couche de résine 30 par le deuxième rayonnement $R_2$ au travers du deuxième masque 200. Dans le présent mode de réalisation, le deuxième masque 200 correspond au premier masque 100 ayant subi une translation relativement au substrat 10. Pour ce faire, il est possible de déplacer le premier masque 100, le substrat 10 ou bien les deux.

Le passage de la figure 5D à la figure 5E illustre le développement de la deuxième couche de résine 30. On obtient ainsi une pluralité de deuxièmes structures 35 chacune formée par une portion de la deuxième couche de résine 30 et une portion de la couche résiduelle 23.

Comme illustré, la hauteur $h_{351}$, $h_{352}$, $h_{353}$, $h_{354}$ de chaque deuxième structure 35 se trouve dans la deuxième gamme $\Delta_2$. Du fait de l'emploi du même masque 100 pour les deux étapes d'exposition au rayonnement d'insolation, la hauteur $h_{351}$, $h_{352}$, $h_{353}$, $h_{354}$ de chaque deuxième structure 35 est égale à la somme de l'épaisseur $e_{23}$ locale de la couche résiduelle 23 et de la hauteur $h_{251}$, $h_{252}$, $h_{253}$, $h_{254}$ de la première structure 25 formée par la même zone dans le masque 100 : $h_{351}=e_{23}+ h_{251}$, $h_{352}=e_{23}+ h_{252}$, $h_{352}=e_{23}+ h_{252}$, $h_{352}=e_{23}+ h252$.

Comme illustré, les hauteurs $h_{351}$, $h_{352}$, $h_{353}$ des deuxièmes structures 35 ne sont pas toutes identiques. Comme indiqué précédemment, au moins deux sont différentes entre elles. Sur l'exemple illustré, les deuxièmes structures 35 présentent toutes des hauteurs différentes.

Dans le cas typiquement où la couche résiduelle 23 présente une épaisseur uniforme ($e_{23}$ constante), ce mode de réalisation permet ainsi de former des ensembles de structures 25, 35 présentant les mêmes différences de hauteurs entre elles. Moyennant un dimensionnement adéquat de $e_{23}$, il est possible que les structures 25, 35 présentent toutes de proche en proche une même différence de hauteur.

Comme dans les autres modes de réalisation, avantageusement, l'insolation et le développement de la deuxième couche de résine permet la mise au jour des premières structures 25. Dans ce mode de réalisation, comme illustré sur la figure 5D, le simple déplacement du masque 100 relativement au substrat 10 peut suffire à exposer directement les premières structures 25 et la portion de la deuxième couche de résine 30 les recouvrant au deuxième rayonnement $R_2$. Il n'est donc pas nécessaire de prévoir dans le masque 100 des zones transparentes dédiées à l'insolation directe de la région des premières structures 25.

Ainsi, dans ce mode de réalisation, un unique masque 100 permet la formation des premières structures 25 dans la première gamme de hauteurs $\Delta_1$ et des deuxièmes structures 35 dans la deuxième gamme de hauteurs $\Delta_2$.

Il est entendu que les trois modes de réalisation décrits ci-dessus ont été décrits pour une résine photosensible positive. L'invention s'applique cependant également aux résines négatives. Les principes des deux modes de réalisation principaux (deuxièmes structures fabriquées sans ou avec couche résiduelle de la première couche de résine) pourront être mis en œuvre en employant des zones opaques à la place de zones transparentes sur le premier masque 100 et sur le deuxième masque 200, et inversement.

Il est entendu par ailleurs que le procédé peut se poursuivre avec le dépôt d'une ou plusieurs autres couches de résine photosensible et la formation d'autres structures, sur les mêmes principes que ceux décrits pour deux ensembles de structures 25, 35. La figure 5F notamment illustre le résultat pouvant être obtenu après avoir déposée une troisième couche de résine et l'avoir exposée au travers du premier masque 100 ayant subi une autre translation relativement au substrat 10. Ces étapes ont permis la formation de troisièmes structures 45 dont la hauteur de chacune est comprise dans une troisième gamme de hauteurs $\Delta_3$. Cette troisième gamme de hauteurs $\Delta_3$ est disjointe à la fois de $\Delta_1$ et de $\Delta_2$. A nouveau, les troisièmes structures 45 formées ne présentent pas toutes la même hauteur. Sur l'exemple illustré, les troisièmes structures 45 présentent toutes des hauteurs différentes.

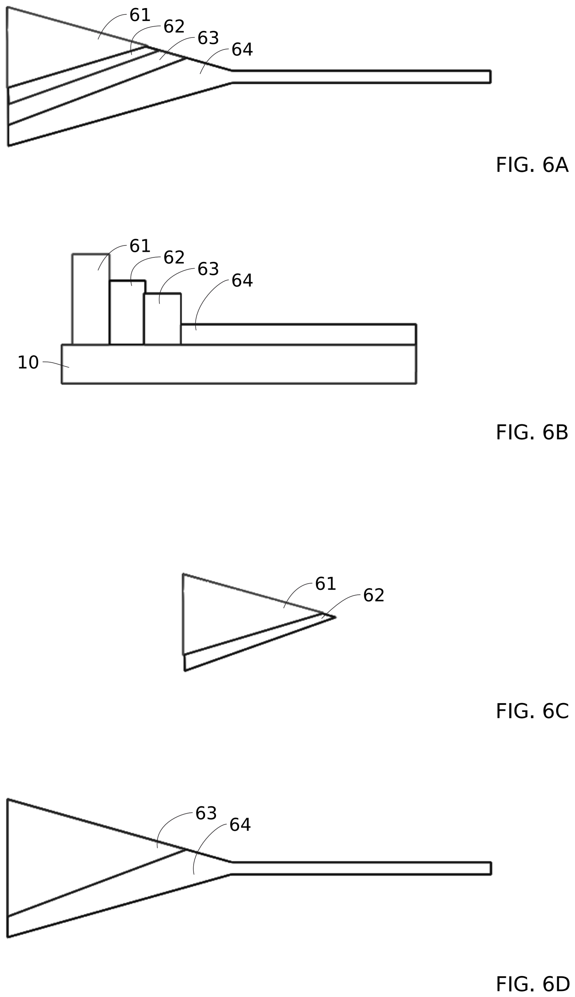

Les figures 6A à 6D illustrent la possibilité d'utiliser la présente invention pour la fabrication de divers dispositifs, en l'occurrence d'un coupleur photonique.

Comme illustré sur les figures 6A (vue de dessus) et 6B (vue en coupe), un coupleur photonique est formé de plusieurs structures 61, 62, 63, 64 à base d'un matériau diélectrique. Le procédé selon l'invention peut être utilisé pour fabriquer un moule qui servira à la fabrication d'un tel coupleur. **Il** est notamment possible de former dans un premier temps des structures en résine correspondant à une partie des structures du coupleur (par exemple les structures 61 et 62, voir figure 6C), puis des structures en résine correspondant au reste de ces structures (par exemple les structures 63 et 64, voir figure 6C).

Au regard des différents modes de réalisation décrits ci-dessus, il apparaît que la présente invention fournit une solution efficace pour améliorer la précision sur la hauteur des structures formées par photolithographie.

L'invention n'est pas limitée aux modes de réalisations précédemment décrits et s'étend à tous les modes de réalisation couverts par l'invention.

## Revendications

**1.** Procédé de lithographie en échelle de gris comprenant :

• une fourniture d'un substrat (10) présentant une face supérieure (11) s'étendant principalement dans un plan horizontal (XY), le substrat (10) étant recouvert d'une première couche de résine photosensible (20),

• une exposition de la première couche de résine photosensible (20) à un premier rayonnement d'insolation ($R_1$) au travers d'un premier masque (100) puis un développement de la première couche de résine photosensible (20), le premier masque (100) étant configuré pour qu'une fois la première couche de résine (20) développée, celle-ci présente un ensemble de premières structures (25) présentant chacune une hauteur comprise dans une première gamme de hauteurs ($\Delta_1$), la hauteur des premières structures (25) étant mesurée selon une direction dite verticale (Z) perpendiculaire au plan horizontal (XY),

• une formation sur la face supérieure (11) du substrat (10) d'une deuxième couche de résine photosensible (30),

• une exposition de la deuxième couche de résine photosensible (30) à un deuxième rayonnement d'insolation ($R_2$) au travers d'un deuxième masque (200) et un développement de la deuxième couche de résine photosensible (30), le premier masque (100) et le deuxième masque (200) étant configurés pour que le développement de la deuxième couche de résine (30) permette la formation d'un ensemble de deuxièmes structures (35) présentant chacune une hauteur comprise dans une deuxième gamme de hauteurs ($\Delta_2$) disjointe de la première gamme de hauteurs ($\Delta_1$), la hauteur des deuxièmes structures (35) étant mesurée selon la direction verticale (Z), les premières structures (25) et les deuxièmes structures (35) se trouvant dans des zones distinctes en projection dans le plan horizontal (XY), le premier masque (100) et le deuxième masque (200) étant par ailleurs configurés pour qu'au sein de l'ensemble de premières structures (25), au moins deux premières structures (25) présentent des hauteurs distinctes, et pour qu'au sein de l'ensemble de deuxième structures (35), au moins deux deuxièmes structures (35) présentent des hauteurs distinctes.

**2.** Procédé selon la revendication précédente dans lequel le premier masque (100) et le deuxième masque (200) sont configurés pour que la première gamme de hauteurs ($\Delta_1$) et la deuxième gamme de hauteurs ($\Delta_2$) s'étendent chacune sur une plage inférieure ou égale à 300 nm, de préférence inférieure ou égale à 200 nm, de préférence inférieure ou égale à 100 nm.

**3.** Procédé selon l'une quelconque des revendications précédentes dans lequel le premier masque (100) et le deuxième masque (200) sont configurés de sorte que les hauteurs des premières structures (25) sont inférieures aux hauteurs des deuxièmes structures (35).

**4.** Procédé selon l'une quelconque des revendications précédentes comprenant en outre, après l'exposition et le développement de la première couche de résine photosensible (20) et avant la formation de la deuxième couche de résine photosensible (30), un durcissement de la première couche de résine photosensible.

5. Procédé selon l'une quelconque des revendications précédentes dans lequel le premier masque (100) présente des zones transparentes au premier rayonnement d'insolation ($R_1$), de manière à ce que le développement de la première couche de résine (20) provoque, en dehors des premières structures (25), son retrait sur toute sa hauteur selon la direction verticale (Z).

6. Procédé selon l'une quelconque des revendications précédentes dans lequel le premier masque (100) est configuré pour qu'une fois la première couche de résine (20) développée, celle-ci présente, en dehors des premières structures (25), une couche résiduelle (23), et dans lequel chacune des deuxièmes structures (35) comprend une partie de la couche résiduelle (23).

7. Procédé selon la revendication précédente dans lequel le premier masque (100) présente des zones opaques au premier rayonnement d'insolation ($R_1$), de manière à ce que la couche résiduelle (23) présente au moins localement une hauteur égale à une hauteur de la première couche de résine (20) avant insolation et développement, la hauteur de la couche résiduelle (23) et la hauteur de la première couche de résine (20) étant mesurée selon la direction verticale (Z).

8. Procédé selon l'une quelconque des deux revendications précédentes dans lequel le deuxième masque (200) est le premier masque (100) ayant subi une translation relativement au substrat (10).

9. Procédé selon l'une quelconque des revendications précédentes dans lequel la deuxième couche photosensible (30) est déposée sur les premières structures (25), et dans lequel le deuxième masque (200) présente des zones transparentes au deuxième rayonnement d'insolation ($R_2$), de manière à ce que le développement de la deuxième couche de résine (20) provoque la mise au jour des premières structures (25).

10. Procédé selon l'une quelconque des revendications précédentes dans lequel les au moins deux premières structures (25) présentant des hauteurs distinctes présentent une différence de hauteur, dite première différence de hauteur, supérieure ou égale à 20 nm.

11. Procédé selon l'une quelconque des revendications précédentes dans lequel les au moins deux deuxièmes structures (35) présentant des hauteurs distinctes présentent une différence de hauteur, dite deuxième différence de hauteur, supérieure ou égale à 20 nm.

12. Utilisation du procédé selon l'une quelconque des revendications précédentes dans la fabrication d'un dispositif photonique pris parmi : un filtre multispectral, un réseau de phase, un imageur, un coupleur.

FIG. 1A

FIG. 1B

FIG. 1C

FIG. 1D

FIG. 2A

FIG. 2B

Bande spectrale

FIG. 2C

FIG. 3A

FIG. 3B

FIG. 3C

FIG. 3D

FIG. 3E

FIG. 4A

FIG. 4B

FIG. 4C

FIG. 4D

FIG. 4E

FIG. 5A

FIG. 5B

FIG. 5C

FIG. 5D

FIG. 5E

FIG. 5F

FIG. 6A

FIG. 6B

FIG. 6C

FIG. 6D

**EP 4 764 703 A1**

Europäisches Patentamt
European Patent Office
Office européen des brevets

# RAPPORT DE RECHERCHE EUROPEENNE

Numéro de la demande

EP 25 22 3754

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2019/278005 A1 (YOUNG ET AL) 12 septembre 2019 (2019-09-12) * alinéas [0037] - [0048] * * figures 1, 2, 10, 11 * ----- | 1-12 | INV. G03F7/00 G03F7/095 G03F7/20 G02B3/00 |
| A | CN 114 895 389 A (UNIV ANHUI) 12 août 2022 (2022-08-12) * figure 2 * * revendication 1 * ----- | 1-12 | |
| A | CN 113 238 306 A (UNIV FUZHOU) 10 août 2021 (2021-08-10) * figure 1 * * revendication 2 * ----- | 1-12 | |
| A | SCHMIDT ET AL: "ALIGNED DOUBLE EXPOSURE IN DEEP X-RAY LITHOGRAPHY", MICROELECTRONIC ENGINEERING, vol. 30, no. 1/04, 1 janvier 1996 (1996-01-01), pages 235-238, XP000588020, ISSN: 0167-9317, DOI: 10.1016/0167-9317(95)00235-9 * figure 1 * * Introduction * ----- | 1-12 | **DOMAINES TECHNIQUES RECHERCHES (IPC)** G03F |
| A | US 2024/302737 A1 (PALANCHOKE) 12 septembre 2024 (2024-09-12) * alinéa [0129] * * figure 1b * ----- | 1-12 | |

Le présent rapport a été établi pour toutes les revendications

| Lieu de la recherche | Date d'achèvement de la recherche | Examinateur |
|---|---|---|
| Munich | 15 avril 2026 | Subke, Kai-Olaf |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..........................................................................
& : membre de la même famille, document correspondant

EPO FORM 1503 03.82 (P4C02)

**ANNEXE AU RAPPORT DE RECHERCHE EUROPEENNE
RELATIF A LA DEMANDE DE BREVET EUROPEEN NO.**

EP 25 22 3754

15-04-2026

| Document brevet cité au rapport de recherche | Date de publication | Membre(s) de la famille de brevet(s) | Date de publication |
|---|---|---|---|
| US 2019278005 A1 | 12-09-2019 | CN 111819497 A | 23-10-2020 |
| | | CN 118091808 A | 28-05-2024 |
| | | EP 3762778 A1 | 13-01-2021 |
| | | EP 4606560 A2 | 27-08-2025 |
| | | JP 7225256 B2 | 20-02-2023 |
| | | JP 2021516367 A | 01-07-2021 |
| | | KR 20200119345 A | 19-10-2020 |
| | | TW 201945842 A | 01-12-2019 |
| | | TW 202142954 A | 16-11-2021 |
| | | TW 202210939 A | 16-03-2022 |
| | | US 2019278005 A1 | 12-09-2019 |
| | | US 2022082738 A1 | 17-03-2022 |
| | | US 2024184024 A1 | 06-06-2024 |
| | | WO 2019173383 A1 | 12-09-2019 |
| CN 114895389 A | 12-08-2022 | AUCUN | |
| CN 113238306 A | 10-08-2021 | AUCUN | |
| US 2024302737 A1 | 12-09-2024 | EP 4428614 A1 | 11-09-2024 |
| | | FR 3146525 A1 | 13-09-2024 |
| | | JP 7592916 B2 | 02-12-2024 |
| | | JP 2024127878 A | 20-09-2024 |
| | | US 2024302737 A1 | 12-09-2024 |

EPO FORM P0460